# EUROPÄISCHE PATENTSCHRIFT

(11) **EP 0 337 012 B1**
(45) Veröffentlichungstag und Bekanntmachung des Hinweises auf die Patenterteilung: **05.01.1994**
(21) Anmeldenummer: 88118894.0
(22) Anmeldetag: 12.11.1988
(51) Int. Cl.: H01J 37/34, C23C 14/34

(54) **Zerstäubungskathode nach dem Magnetron-Prinzip**
Sputtering cathode following the magnetron principle
Cathode pour pulvérisation selon le principe magnétron

(30) Priorität: 14.04.1988 DE 3812379
(43) Veröffentlichungstag der Anmeldung: 18.10.1989
(73) Patentinhaber: LEYBOLD AKTIENGESELLSCHAFT, D-63450 Hanau (DE)
(72) Erfinder: Maass, Wolfram, Dr., D-6455 Erlensee (DE); Cord, Bernhard, Dr., D-8755 Alzenau (DE); Ferenbach, Dagmar, D-5100 Aachen (DE); Martens, Thomas, D-8752 Krombach (DE); Wirz, Peter, Dr., D-6296 Waldernbach (DE)

(56) Entgegenhaltungen:
- EP-A- 0 253 344
- US-A- 4 426 264
- PATENT ABSTRACTS OF JAPAN vol. 8, no. 190 (E-263)(1627) 31 August 1984, & JP-A-59 79 528

## Beschreibung

Die Erfindung betrifft eine Vorrichtung mit einer Zerstäubungskathode nach dem Magnetron-Prinzip mit einem aus mindestens einem Teil bestehenden Target, mit einem hinter dem Target angeordneten Magnetsystem mit mehreren, ineinanderliegenden und in sich geschlossenen Magneteinheiten abwechselnd unterschiedlicher Polung, durch die mindestens zwei gleichfalls in sich geschlossene, ineinanderliegende magnetische Tunnels aus bogenförmig gekrümmten Feldlinien gebildet werden, wobei die dem Target abgekehrten Pole der Magneteinheiten über ein Magnetjoch miteinander verbunden sind und wobei die magnetische Feldstärke mindestens eines Magnetfeldes relativ zu der magnetischen Feldstärke mindestens eines weiteren Magnetfeldes über ein Verschieben eines der Jochteile zum Target über eine Verstelleinrichtung veränderbar ist.

Durch die DE-A-34 42 206 ist eine Zerstäubungskathode der eingangs beschriebenen Gattung bekannt, die für die Zerstäubung von Targets aus ferromagnetischen Werkstoffen vorgesehen ist. Bei einem der beiden Ausführungsbeispiele werden durch zwei konzentrisch ineinanderliegende Magneteinheiten in Verbindung mit zwei konzentrischen, in dem Target angeordneten Luftspalten zwei in sich geschlossene, ineinanderliegende magnetische Tunnels aus bogenförmig gekrümmten Feldlinien gebildet. Da aber hierbei die magnetischen Felder über die beiden Luftspalte magnetisch in Reihe geschaltet sind, lassen sich die Feldstärken der beiden Tunnels nicht unabhängig voneinander beeinflussen. Dadurch entstehen im Bereich der beiden magnetischen Tunnels voneinander verschiedene Zerstäubungsraten und im Bereich des dem Target gegenüberliegenden Substrats auch sehr unterschiedliche Niederschlagsraten, so daß die Schichtdickenverteilung sehr ungleichförmig ist.

Durch die DE-A-22 43 708 ist es bekannt, bei Stabkathoden Magneteinheiten in axialer Richtung hintereinander anzuordnen, um dadurch die Zerstäubung des Targetmaterials zu vergleichmäßigen. Auch für die dort beschriebenen planaren Targets wird angegeben, daß man konzentrische, ineinanderliegende Magneteinheiten und mehrere konzentrisch ineinanderliegende magnetische Tunnels vorsehen kann. Auch hier sind Möglichkeiten einer getrennten Einstellung eines jeden magnetischen Tunnels unabhängig vom jeweils benachbarten Tunnel nicht vorgesehen und auch nicht möglich.

Durch eine unter der Bezeichnung "Con Mag" von der Firma Varian vertriebene Zerstäubungskathode der eingangs beschriebenen Gattung ist es weiterhin bekannt, innerhalb einer kreisringförmigen Jochplatte mit Abstand eine kreisscheibenförmige Jochplatte vorzusehen und jeder Jochplatte zwei unabhängig voneinander wirkende, entgegengesetzt gepolte Magneteinheiten zuzuordnen, wobei über dem kreisringförmigen Magnetsystem ein Target mit einer kegelförmigen Zerstäubungsfläche und über dem kreisscheibenförmigen Magnetsystem eine ebene Targetplatte angeordnet ist. Mittel für die Beeinflussung der Magnetfeldstärke der zwei gebildeten Tunnels unabhängig voneinander sind nicht vorgesehen. Auch bei dieser Zerstäubungskathode muß der Zerstäubungseffekt so in Kauf genommen werden, wie er durch die relative Lage der magnetischen Tunnels zu den Zerstäubungsfläche vorgegeben ist.

Die weiter oben beschriebene Zerstäubungskathode "Con Mag" der Firma Varian entspringt dem Versuch, die Schichtdickenverteilung zu verbessern, indem man nicht nur die Magnetsysteme, sondern auch die zugehörigen Targetteile elektrisch völlig entkoppelt hat. Dies setzt jedoch den Einsatz von zwei Stromquellen pro Zerstäubungskathode voraus, weiterhin auch eine elektrische Isolation der Target- bzw. Kathodenteile voneinander. Für die Zerstäubung von Targets aus ferromagnetischen Werkstoffen ist ein solches System nicht geeignet.

Schließlich wurde bereits eine Zerstäubungskathode nach dem Magnetron-Prinzip vorgeschlagen (EP-A-253344= DE-A-36 24 150) mit einem mindestens aus einem Teil bestehenden Target, mit einem hinter dem Target angeordneten Magnetsystem mit mehreren, ineinanderliegenden und in sich geschlossenen Magneteinheiten abwechselnd unterschiedlicher Polung, durch die mindestens zwei gleichfalls in sich geschlossene, ineinanderliegende magnetische Tunnels aus bogenförmig gekrümmten Feldlinien gebildet werden, wobei die dem Target abgekehrten Pole der Magneteinheiten über ein Magnetjoch miteinander verbunden sind und wobei die magnetische Feldstärke mindestens eines einen magnetischen Tunnel bildenden Magnetfeldes relativ zu der magnetischen Feldstärke mindestens eines weiteren, einen weiteren magnetischen Tunnel bildenden Magnetfeldes durch Verschieben einer Magneteinheit veränderbar ist.

Diese Zerstäubungskathode hat noch den Nachteil, daß die Schichtdickengleichmäßigkeit auf dem Substrat nicht in jedem Falle gewährleistet ist, da sie auch wesentlich vom Targetalter abhängt.

Der vorliegenden Erfindung liegt deshalb die Aufgabe zugrunde, eine Vorrichtung zu schaffen, die selbsttätig die Verschiebung der Magneteinheit bewirkt, und zwar in Abhängigkeit der Targetabnutzung.

Die Lösung der gestellten Aufgabe erfolgt mit einer Vorrichtung mit einer Zerstäubungskathode gemaß Anspruch 1. Die abhängigen Patentansprüche beschreiben besondere Ausführungsarten der Erfindung.

Die Erfindung läßt die verschiedensten Ausführungsmöglichkeiten zu; eine davon ist in den anhängenden Zeichnungen rein schematisch näher dargestellt, und zwar zeigen:
- **Fig. 1**: den Schnitt quer durch eine Zerstäubungskathode mit einer verschiebbaren Magneteinheit
- **Fig. 2**: die Draufsicht auf ein kreisscheibenförmiges Substrat

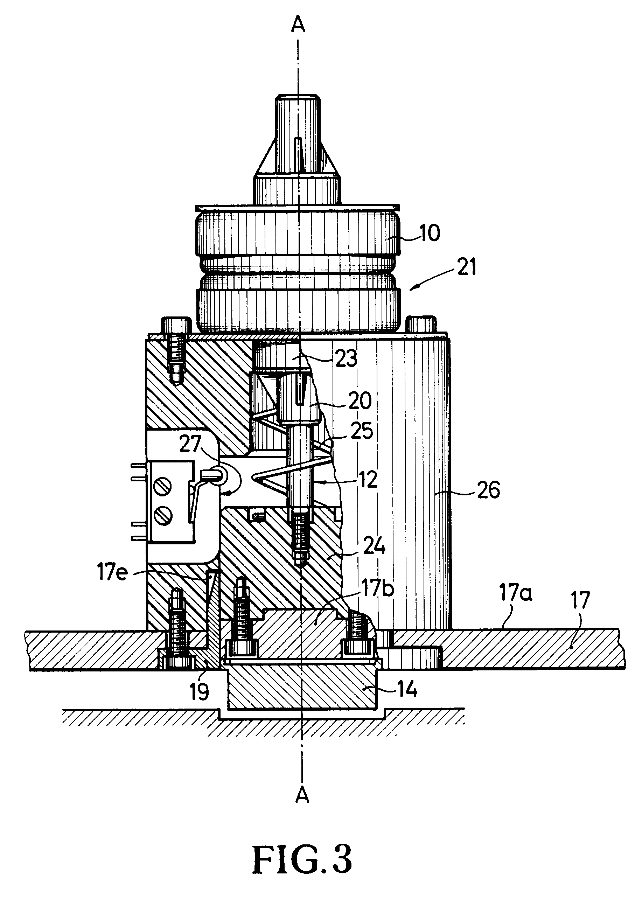

- **Fig. 3**: den Schnitt quer durch die Verstelleinrichtung der Zerstäubungskathode gemäß Fig. 1 in vergrößerter Darstellung

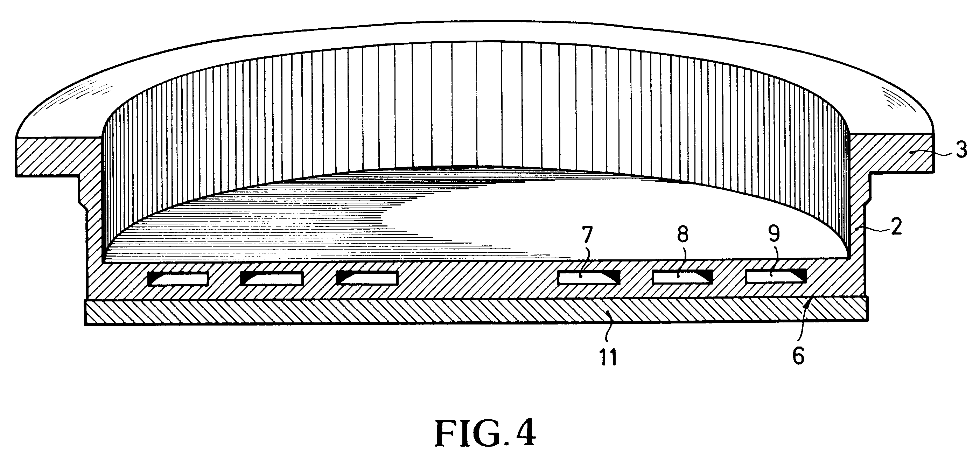

- **Fig. 4**: die perspektivische Schnittdarstellung des topfförmigen Grundkörpers der Kathode gemäß Fig. 1

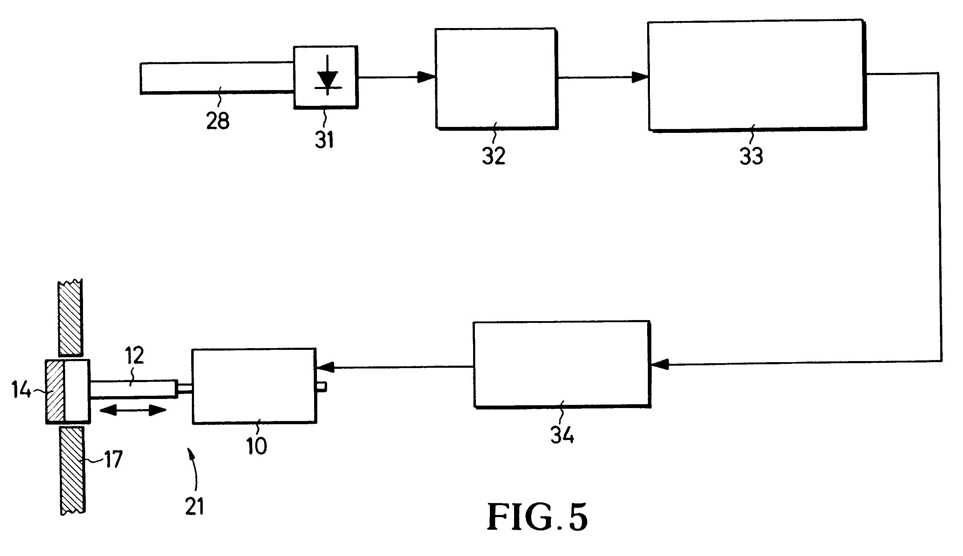

- **Fig. 5**: das Schaltschema der Ansteuereinrichtung (Regelkreis) der Verstelleinrichtung

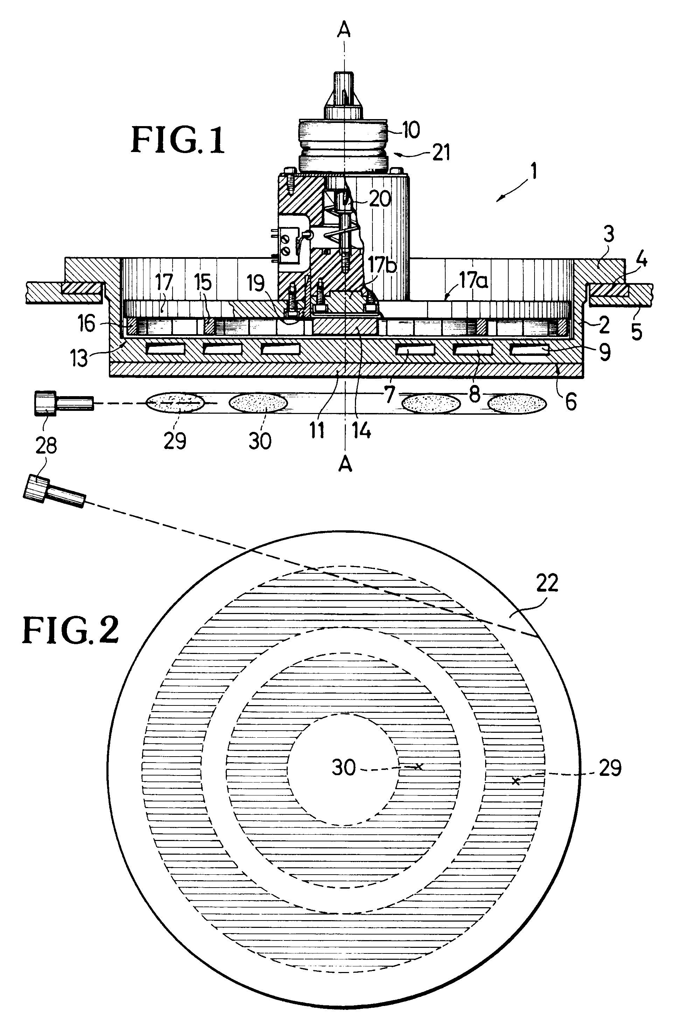

In Figur 1 ist eine Zerstäubungskathode 1 dargestellt, deren tragender Teil ein topfförmiger, hohler Grundkörper 2 ist, der wegen der thermischen Belastung aus einem gut wärmeleitenden Werkstoff (Kupfer) besteht und mittels eines umlaufenden Flansches 3 unter Zwischenschaltung eines Isolierstoffkörpers 4 in eine Wand 5 einer hier nicht näher gezeigten Vakuumkammer eingesetzt ist.

Der Grundkörper 2 besitzt eine größtenteils ebene Stirnplatte 6. Auf der Innenseite der Stirnplatte 6 befinden sich drei konzentrische Kühlwasserkanäle 7, 8, 9.

Auf der Außenseite der Stirnplatte 6 ist durch eine Verbindung (Bonden) ein Target 11 befestigt. In der hinteren Öffnung des Grundkörpers 2 befindet sich ein Magnetsystem 13 mit mehreren Magneteinheiten 14, 15, 16, die in bezug auf die Achse A-A ineinanderliegen und sämtlich aus permanentmagnetischem Material bestehen und in axialer Richtung magnetisiert sind. Die zentrale Magneteinheit 14 hat dabei die Form eines gedrungenen Zylinders. Die Magneteinheiten 15, 16 sind dabei aus mehreren quaderförmigen Permanentmagneten zusammengesetzt, deren Polflächen gleicher Polung jeweils im wesentlichen in einer Kreisringfläche liegen. Hierbei sei vernachlässigt, daß eine solche Aneinanderreihung von Permanentmagneten in Wirklichkeit zu einem Polygon führt. Die dem Target 11 abgekehrten Pole der Magneteinheiten 14, 15, 16 sind über ein Magnetjoch 17 aus weichmagnetischem Material in der in Figur 1 gezeigten Weise miteinander verbunden. Das Magnetjoch 17 besteht dabei aus einem äußeren Jochteil 17a, dessen Grundfläche eine Kreisringfläche ist, und aus einem inneren Jochteil 17b, dessen Grundfläche eine Kreisfläche ist.

Die Magneteinheiten sind dabei abwechselnd unterschiedlich gepolt, und zwar bilden die dem Target 11 zugekehrten Polflächen bei der Magneteinheit 14 einen Nordpol, bei der Magneteinheit 15 einen Südpol und bei der Magneteinheit 16 wieder einen Nordpol. Dies führt im Hinblick auf die zwischen dem Target 11 vorhandenen Luftspalte zur Ausbildung zweier magnetischer Tunnels, die um die Achse A-A umlaufend geschlossen sind.

Das innere Jochteil 17b ist in einer Ausnehmung 17e des äußeren Jochteils 17a in Normalenrichtung zur Hauptebene des Targets 11, d.h. in Richtung der Achse A-A unter Veränderung der Überlappung verstellbar. Zur Verstellung dient eine Verstelleinrichtung 21, durch die der innere Jochteil 17b verschoben werden kann. Da zwischen den beiden Jochteilen 17a und 17 eine Gleitführung über die Hülse 19 besteht, läßt sich durch Heben oder Senken des Führungsteils 24 mit Spindel 12 der Verstelleinrichtung 21 das innere Jochteil 17b aus dem äußeren Jochteil 17a heraus oder in dieses hinein bewegen. Durch die Verstelleinrichtung 21 wird erreicht, daß der magnetische Fluß zwischen dem Magnetjoch 17 und der Magneteinheit 14 gegenüber dem magnetischen Fluß zwischen dem gleichen Magnetjoch 17 und den übrigen Magneteinheiten 15, 16 verändert wird. Der magnetische Fluß zwischen den Magneteinheiten 15, 16 bleibt hiervon jedenfalls im wesentlichen unbeeinflußt. Diese Maßnahme führt dazu, daß die magnetische Feldstärke des den einen Tunnel bildenden Magnetfeldes relativ zu der magnetischen Feldstärke des den anderen Tunnel bildenden Magnetfeldes verändert wird. Auf diese Weise lassen sich die Zerstäubungsraten im Bereich der beiden magnetischen Tunnel unabhängig voneinander verändert, womit sich die örtlichen Schichtdicken auf dem Substrat 22 gezielt beeinflussen lassen, das dem Target 11 gegenüber in einem üblichen Abstand angeordnet ist und mit dem Material des Targets 11 (oder einem Reaktionsprodukt hieraus) beschichtet werden soll.

Die Verstelleinrichtung ist beim dargestellten Ausführungsbeispiel als Elektromotor 10 ausgebildet, dessen Rotor eine sich längs der Rotationsachse des Läufers erstreckende Gewindebohrung aufweist, mit der die Spindel 12 zusammenwirkt, die ihrerseits mit einer mittleren Partie 20 versehen ist, die als Sechskant ausgebildet ist und in einer Buchse 23 mit zentralem Sechskantloch geführt ist.

Wenn nun der Elektromotor oder Aktuator 10 mit elektrischer Spannung versorgt wird, verschiebt sich die Spindel 12, je nach Motordrehrichtung längs der vertikalen Achse A-A auf- und abwärts. Da die zentrale Magneteinheit 14 mit dem inneren Jochteil 17b verbunden ist, beispielsweise mit diesem verklebt ist, und das Jochteil 17b seinerseits mit dem Führungsteil 24, das in der Hülse 19 gelagert und mit der Spindel 12 fest verbunden ist, kann das Magnetteil 14 auf diese Weise um ein genau kontrollierbares Maß verschoben werden, und zwar gegen die Kraft einer Druckfeder 25, die sich einerseits am den Elektromotor 10 tragenden Sockelteil 26 und andererseits am in einer Bohrung 27 des Sockelteils 26 geführten Führungsteils 24 abstützt.

Unterhalb des Targets 11 ist ein optischer Sensor 28 am Gehäuse der Beschichtungskammer ortsfest angeordnet. Wird nun in die evakuierte Beschichtungskammer ein Argon-Gas eingelassen und steht dabei die Kathode unter Spannung, dann bilden sich zwei Plasmaringe 29, 30 im Bereich der magnetischen Tunnels aus. Da die Helligkeit der Plasmaringe 29, 30 von der Gesamtleistung der Kathode und der Stellung der Permanentmagnete 14, 15 bzw. 15, 16 zueinander abhängig ist, ermöglicht die genaue Beobachtung des einen Plasmarings 29 (oder auch beider Plasmaringe 29, 30) Rückschlüsse auf die Güte und Gleichmäßigkeit der Beschichtung, beispielsweise eines kreisscheibenförmigen Substrats 22. Diese Beobachtung des Plasmarings 29 geschieht nun über den optischen Sensor 28, der zwischen dem Substrat 29 und dem Target 11 angebracht ist. Die von diesem Sensor 28 gewonnenen Informationen ermöglichen einen Regelkreis, der es insbesondere auch erlaubt, die durch den Abtrag des Targets verursachten Veränderungen der Ratenverteilung zu kompensieren. Der Sensor 28 gestattet die Bestimmung der Helligkeit (integral über einen weiten Bereich des optischen Spektrums) des Plasmarings 29 und besteht aus einem Kollimator, einem Linsensystem, einem Lichtleiter, einer Fotodiode und einem Vorverstärker 31 (in der Zeichnung nicht näher dargestellt). Die am Verstärker 32 anstehenden Signale werden mittels eines A/D-Wandlers von einem Rechner 33 aufgenommen und ausgewertet und dann an die Schrittmotoransteuerung 34 weitergegeben, der seinerseits mit dem Aktuator bzw. dem Schrittmotor 10 verbunden ist.

### Auflistung der Einzelteile

- 1: Zerstäubungskathode
- 2: topfförmiger Grundkörper
- 3: umlaufender Flansch
- 4: Isolierstoffkörper
- 5: Wand
- 6: Stirnplatte
- 7: Kühlwasserkanal
- 8: Kühlwasserkanal
- 9: Kühlwasserkanal
- 10: Elektromotor, Aktuator, Stellmotor
- 11: Target
- 12: Spindel
- 13: Magnetsystem
- 14: Magneteinheit
- 15: Magneteinheit
- 16: Magneteinheit
- 17: Magnetjoch
- 17a: äußeres Jochteil
- 17b: inneres Jochteil
- 17e: Ausnehmung des äußeren Jochteils
- 19: Hülse
- 20: mittlere Partie der Spindel
- 21: Verstelleinrichtung
- 22: Substrat
- 23: Buchse mit zentralem Sechskantloch
- 24: Führungsteil
- 25: Druckfeder
- 26: Sockelteil
- 27: Bohrung
- 28: optischer Sensor
- 29: Plasmaring
- 30: Plasmaring
- 31: Vorverstärker
- 32: Verstärker
- 33: Rechner
- 34: Schrittmotoransteuerung

## Patentansprüche

1. Vorrichtung mit einer Zerstäubungskathode nach dem Magnetron-Prinzip mit einem aus mindestens einem Teil bestehenden Target (11), mit einem hinter dem Target (11) angeordneten Magnetsystem, mit mehreren, ineinanderliegenden und in sich geschlossenen Magneteinheiten (14, 15, 16) abwechselnd unterschiedlicher Polung, durch die mindestens zwei gleichfalls in sich geschlossene, ineinanderliegende magnetische Tunnels aus bogenförmig gekrümmten Feldlinien gebildet werden, wobei die dem Target (11) abgekehrten Pole der Magneteinheiten (14, 15, 16) über ein Magnetjoch (17, 17a, 17b) miteinander verbunden sind und wobei die magnetische Feldstärke mindestens eines Magnetfeldes relativ zu der magnetischen Feldstärke mindestens eines weiteren Magnetfeldes über ein Verschieben eines der Jochteile (14) zum Target (11) über eine Verstelleinrichtung (21) veränderbar ist, **dadurch gekennzeichnet,** daß die Vorrichtung einen Regelkreis (32, 33, 34) mit einem optischen Sensor (28) enthält, der auf mindestens einen der sich beim Beschichtungsvorgang einstellenden Plasmaringe (29) ausgerichtet ist und auf die Helligkeit dieses Plasmarings (29) oder dieser Plasmaringe anspricht, und die Verstelleinrichtung (21) über den elektrischen Regelkreis (32, 33, 34) gesteuert wird.

2. Vorrichtung nach Anspruch 1, **dadurch gekennzeichnet,** daß über einen optischen Sensor (28) der radial äußere Plasmaring (29) erfaßt und mit dem vom Sensor (28) erzeugten Signal bei gegebener Kathodenleistung das Leistungsverhältnis des einen zum anderen Plasmaring (29, 30) vom Regelkreis (32, 33, 34) bestimmt und ein entsprechendes Signal an die mit dem Stellmotor (10) zusammenwirkende Motoransteuerung (34) geleitet wird.

3. Vorrichtung nach den Ansprüchen 1 und 2, **dadurch gekennzeichnet,** daß der Rotor des Stellmotors (10) mit einer Gewindespindel (12) zusammenwirkt, deren eines Ende mit dem inneren Jochteil (17b) gekoppelt ist, das seinerseits fest mit der Magneteinheit (14) verbunden ist.

4. Vorrichtung nach den vorherigen Ansprüche, **dadurch gekennzeichnet,** daß das mit der Gewindespindel (12) gekoppelte Jochteil (17b) mit Magneteinheit (14) gegen die Kraft einer Feder (25) verschiebbar ist, die sich einerseits an einem den Schrittmotor (10) tragenden, ortsfesten Sockelteil (26) und andererseits an einem Führungsteil (24) abstützt, das mit dem Jochteil (17b) verbunden und in einer Bohrung (27) des Sockelteils (26) geführt ist.

## Claims

1. Device having a sputtering cathode according to the magnetron principle, a target (11) consisting of at least one part, a magnet system disposed behind the target (11), a plurality of nested and enclosed magnet units (14, 15, 16) of alternately different polarity, which give rise to at least two likewise enclosed, nested magnetic tunnels of arcuate field lines, wherein the poles of the magnet units (14, 15, 16) remote from the target (11) are connected together via a magnet yoke (17, 17a, 17b) and wherein the magnetic field strength of at least one magnetic field relative to the magnetic field strength of at least one further magnetic field is variable by displacement of one of the yoke parts (14) relative to the target (11) via an adjuster (21), characterised in that the device comprises a control circuit (32, 33, 34) with an optical sensor (28), which is oriented towards at least one of the plasma rings (29) formed during the coating operation and responds to the brightness of that plasma ring (29) or those plasma rings, and the adjuster (21) is controlled via the electric control circuit (32, 33, 34).

2. Device according to claim 1, characterised in that the radially outer plasma ring (29) is detected via an optical sensor (28), and the power ratio of one plasma ring to the other (29, 30) is determined by the control circuit (32, 33, 34) with the signal generated by the sensor (28) at a given cathode power, and a corresponding signal is sent to the motor drive (34) cooperating with the stepper motor (10).

3. Device according to claims 1 and 2, characterised in that the rotor of the stepper motor (10) cooperates with a threaded spindle (12), one end of which is coupled to the inner yoke portion (17b), which is in turn connected rigidly to the magnet unit (14).

4. Device according to the preceding claims, characterised in that the yoke portion (17b) coupled to the threaded spindle (12) is displaceable with the magnet unit (14) against the force of a spring (25), which bears on one side against a stationary pedestal portion (26) supporting the stepper motor (10) and on the other side on a guide portion (24) connected to the yoke potion (17b) and guided in a bore (27) of the pedestal portion (26).

## Revendications

1. Dispositif possédant une cathode pour la pulvérisation selon le principe du magnétron, comprenant une cible (11) en au moins une partie, un système magnétique placé derrière la cible (11) et comportant plusieurs unités magnétiques (14, 15, 16) disposées l'une dans l'autre et fermées en elles-mêmes, ayant des polarités alternantes et par lesquelles sont formés au moins deux tunnels magnétiques disposés l'un dans l'autre, également fermés en eux-mêmes et formés de lignes de champ courbées en arc, dispositif dans lequel les pôles éloignés de la cible (11) des unités magnétiques (14, 15, 16) sont reliés entre eux par une culasse magnétique (17, 17a, 17b) et dans lequel l'intensité de champ magnétique d'au moins un champ magnétique peut être changée par rapport à l'intensité de champ magnétique d'au moins un autre champ magnétique par la translation d'une partie (14) de la culasse par rapport à la cible (11) au moyen d'un dispositif de réglage (21), caractérisé en ce qu'il comporte un circuit de réglage (32, 33, 34) avec un capteur optique (28) dirigé sur au moins l'un des anneaux de plasma (29) créés lors du processus de revêtement et réagissant à la luminosité de cet anneau (29) ou de ces anneaux de plasma, et le dispositif de réglage (21) est commandé par le circuit de réglage électrique (32, 33, 34).

2. Dispositif selon la revendication 1, caractérisé en ce qu'un capteur optique (28) détecte l'anneau de plasma (29) situé radialement à l'extérieur et le signal généré par le capteur (28) sert à la détermination par le circuit de réglage (32, 33, 34) du rapport de puissance de l'un à l'autre anneau de plasma (29, 30), la puissance de la cathode étant préfixée, et à l'envoi d'un signal correspondant à la commande moteur (34) coopérant avec le moteur de positionnement (10) pour la translation.

3. Dispositif selon les revendications 1 et 2, caractérisé en ce que le rotor du moteur de positionnement (10) coopère avec une broche filetée (12) dont une extrémité est couplée à une partie intérieure (17b) de la culasse, partie qui est elle-même reliée fixe à une unité magnétique (14).

4. Dispositif selon les revendications précédentes, caractérisé en ce que la partie de culasse (17b) couplée à la broche filetée (12) est déplaçable en translation, ensemble avec ladite unité magnétique (14), contre la force d'un ressort (25) qui s'appuie d'une part sur un socle stationnaire (26) portant le moteur de positionnement pas à pas (10) et d'autre part sur une pièce de guidage (24) reliée à ladite partie (17b) de la culasse et guidée dans un alésage (27) du socle (26).
